# EUROPÄISCHE PATENTSCHRIFT

(11) **EP 3 295 680 B1**
(45) Veröffentlichungstag und Bekanntmachung des Hinweises auf die Patenterteilung: **10.07.2019**
(21) Anmeldenummer: 16723324.6
(22) Anmeldetag: 10.05.2016
(51) Int. Cl.: H04R 1/28, H04R 31/00, B81B 7/00, B81C 3/00, B81C 99/00

(54) **HERSTELLUNGSVERFAHREN FÜR EINE SCHALLWANDLERANORDNUNG MIT LEITERPLATTENMODUL MIT DURCHGEHENDER AUSSPARUNG**
MANUFACTURING METHOD FOR A SONIC TRANSDUCER ASSEMBLY WITH CIRCUIT BOARD MODULE HAVING CONTINUOUS CAVITY
PROCÉDÉ DE FABRICATION POUR ENSEMBLE TRANSDUCTEUR ACOUSTIQUE AVEC MODULE À CARTE DE CIRCUIT IMPRIMÉ MUNI D'UN ÉVIDEMENT TRAVERSANT

(30) Priorität: 13.05.2015 DE 102015107557
(43) Veröffentlichungstag der Anmeldung: 21.03.2018
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT)
(74) Vertreter: Bergmeier, Werner
(86) Internationale Anmeldenummer: PCT/EP2016/060479
(87) Internationale Veröffentlichungsnummer: WO 2016/180841

(56) Entgegenhaltungen:
- EP-A1- 2 552 124
- DE-A1-102005 053 767
- DE-A1-102011 086 764
- JP-A- 2010 219 950
- US-A- 3 701 865
- US-A- 5 870 482
- US-A1- 2005 185 812
- US-A1- 2012 087 521
- US-A1- 2014 246 739
- US-A1- 2014 294 209
- US-B1- 8 629 005

## Beschreibung

Die vorliegende Erfindung betrifft ein Verfahren zum Herstellen einer Schallwandleranordnung bei dem ein Membranmodul mit einem Leiterplattenmodul verbunden wird, wobei eine Membran des Membranmoduls und eine Aktuatorstruktur des Leiterplattenmoduls, die beide entlang einer gemeinsamen z-Achse auslenkbar sind, zwischen einem Pressstempel und einem Referenzwerkzeug positioniert werden und zwischen diesen beiden verpresst werden, so dass sich die beiden Module in einem ersten Verbindungsbereich miteinander verbinden.

Des Weiteren betrifft die Erfindung eine mit dem vorstehenden Verfahren hergestellte Schallwandleranordnung mit einem Leiterplattenmodul, das eine Leiterplatte mit einer eine erste Öffnung aufweisenden Aussparung und zumindest einen Teil eines MEMS-Schallwandlers umfasst, wobei dieser Teil im Bereich der ersten Öffnung angeordnet ist, so dass die Aussparung zumindest teilweise eine Kavität des MEMS-Schallwandlers bildet, und mit einem Membranmodul, das einen Membranrahmen, der mit dem Leiterplattenmodul verbunden ist, und zumindest eine vom Membranrahmen gehaltene Membran aufweist, wobei die Membran in der Verlängerung der Aussparung mit dem zumindest einen Teil des MEMS-Schallwandlers verbunden ist.

Die Bezeichnung MEMS steht für mikroelektromechanische Systeme. Unter der Begrifflichkeit "Kavität" ist ein Hohlraum zu verstehen, mittels dem der Schalldruck des MEMS-Schallwandlers verstärkt werden kann.

Aus der JP 2010 219950 A ist ein Verfahren zum Herstellen einer Schallwandleranordnung bekannt, bei dem ein Membranmodul mit einem Leiterplattenmodul verbunden wird, wobei eine Membran des Membranmoduls, die entlang einer z-Achse auslenkbar ist, zwischen einem Pressstempel und einem Referenzwerkzeug positioniert wird.

Aus der US 3,701,865 ist ein akustischer Wandler mit einer auf einer Leiterplatte abgestützten Membran bekannt. Die Leiterplatte hat eine Aussparung, durch die sich ein Antriebsstift zum Antreiben der Membran erstreckt.

Aus der DE 10 2011 084 393 A1 ist eine mikromechanische Funktionsvorrichtung, insbesondere Lautsprechervorrichtung, und ein entsprechendes Herstellungsverfahren bekannt. Die Funktionsvorrichtung umfasst ein Substrat, mindestens einen auf dem Substrat angebrachten Schaltungschip, eine Umhüllverpackung, in welcher der Schaltungschip verpackt ist, eine mikromechanische Funktionsanordnung, insbesondere Lautsprecheranordnung, mit einer Mehrzahl von mikromechanischen Lautsprechern, welche auf der Umhüllverpackung angebracht ist, und einer oberhalb der mikromechanischen Funktionsanordnung, insbesondere Lautsprecheranordnung, gegenüberliegend der Umhüllverpackung angebrachten Abdeckeinrichtung. Ein wesentlicher Nachteil solcher Schallwandleranordnungen besteht darin, dass deren Herstellung komplex und kostenaufwendig ist. Des Weiteren sind die Ausschusskosten sehr hoch, da die Schallwandleranordnung erst im vollständig zusammengebauten Zustand getestet werden kann und infolgedessen bei einem Defekt die gesamte Vorrichtung Ausschuss ist.

Aufgabe der vorliegenden Erfindung ist es somit, ein Herstellungsverfahren für eine Schallwandleranordnung und eine mit diesem Verfahren hergestellte Schallwandleranordnung zu schaffen, so dass die Herstellungskosten und die Ausschusskosten reduziert werden können.

Die Aufgabe wird gelöst durch ein Verfahren zum Herstellen einer Schallwandleranordnung sowie durch eine mit diesem Verfahren hergestellte Schallwandleranordnung mit den Merkmalen der unabhängigen Patentansprüche.

Vorgeschlagen wird ein Leiterplattenmodul, das in einer Schallwandleranordnung zum Erzeugen und/oder Erfassen von Schallwellen im hörbaren Wellenlängenspektrum verbaut ist. Das Leiterplattenmodul umfasst eine Leiterplatte und zumindest einen Teil eines MEMS-Schallwandlers. Dieser Teil des MEMS-Schallwandlers kann beispielsweise ein MEMS-Aktuator - insbesondere mit einem Substrat und/oder einer Aktuatorstruktur - oder eine Membran sein. In einem separaten Fertigungsschritt kann dieser mit dem Leiterplattenmodul verbundene Teil des MEMS-Schallwandlers zum vollständigen Ausbilden des MEMS-Schallwandlers mit einem anderen Teilen des MEMS-Schallwandlers verbunden werden.

Die Leiterplatte weist eine Aussparung auf. Die Aussparung umfasst eine erste Öffnung. Der Teil des MEMS-Schallwandlers ist im Bereich der ersten Öffnung angeordnet. Auf diese Weise bildet die Aussparung zumindest teilweise eine Kavität des MEMS-Schallwandlers. Die Aussparung weist eine der ersten Öffnung gegenüberliegende zweite Öffnung auf. Infolgedessen erstreckt sich die Aussparung vollständig durch die Leiterplatte. Vorzugsweise erstreckt sich die Aussparung entlang einer z-Achse, in deren Richtung eine dafür vorgesehene Membran zu schwingen vermag.

Des Weiteren umfasst das Leiterplattenmodul im Bereich der zweiten Öffnung ein erstes Gehäuseteil, das die Kavität verschließt. Hierdurch kann das Leiterplattenmodul als MEMS-Lautsprecher ausgebildet werden.

Durch die zumindest teilweise integrative Ausbildung der Kavität in die Leiterplatte kann das vorgeschlagene Leiterplattenmodul, insbesondere in z-Richtung, sehr bauraumsparend ausgebildet werden, da zusätzliche Bauteile, insbesondere zusätzliche Gehäuseteile, zur vollständigen Ausbildung der Kavität kleiner dimensioniert oder sogar vollständig eingespart werden können. Demnach kann der Leiterplattenhohlraum bzw. die Aussparung im Bereich seiner zweiten Öffnung mittels eines, insbesondere plattenförmigen, Gehäuseteils verschlossen sein, wenn das Volumen der durch die Aussparung ausgebildeten Kavität für den individuellen Anwendungsfall bereits ausreicht. Alternativ kann aber auch zur Steigerung der Leistungsfähigkeit des MEMS-Schallwandlers das Volumen der Aussparung durch ein im Gehäuseteil selbst ausgebildetes Zusatzvolumen erweitert sein, wenn ein höherer Schalldruck benötigt wird. In diesem Fall würde die Kavität zumindest durch das abschließende Gehäuseteil und die Aussparung ausgebildet sein. Infolgedessen kann die Kavität des MEMS-Schallwandlers mittels der durchgehenden Aussparung schnell, einfach und kostengünstig an den jeweiligen Anwendungsfall angepasst werden, ohne hierbei die Leiterplatte verändern zu müssen. Das Leiterplattenmodul ist somit in modularer Bauweise um verschiedene zusätzliche Bauteile erweiterbar und an unterschiedliche Anforderungen anpassbar.

Ein Weiterer Vorteil der durchgehenden Aussparung besteht darin, dass der MEMS-Schallwandler nicht im Ganzen mit der Leiterplatte verbunden sein muss, um die Funktionsfähigkeit seiner elektronischen Komponenten (insbesondere eines MEMS-Aktuators und/oder eines ASIC) testen zu können. So können Teile des MEMS-Schallwandlers und/oder der Schallwandleranordnung aufgrund der durchgehenden Aussparung auch noch nachträglich am Leiterplattenmodul befestigt werden. Hierfür stellt die zweite Öffnung eine Montageöffnung dar, über die ein Montagewerkzeug einführbar ist.

Demnach kann beispielsweise nur der MEMS-Aktuator - ohne die Membran - als Teil des MEMS-Schallwandlers mit der Leiterplatte bzw. mit dem darin vorzugsweise eingebetteten ASIC verbunden sein. Anschließend kann die Funktionsfähigkeit dieser Einheit bzw. dieses Moduls getestet werden. Sollte diese Einheit defekt sein, müssen nur die von dieser Einheit umfassten Komponenten entsorgt werden. Die anderen Komponenten der Schallwandleranordnung, insbesondere die Membran, der Membranträger und/oder zusätzliche Gehäuseteile, können eingespart werden, wodurch die Ausschusskosten reduziert werden.

Wenn der Funktionstest jedoch ein positives Ergebnis liefert, kann das Leiterplattenmodul in einem anschließenden Verbindungsverfahren mit den anderen Komponenten des MEMS-Schallwandlers verbunden werden. Hierfür wird ein Referenzwerkzeug über die zweite Öffnung der Aussparung in diese eingeführt. Das Referenzwerkzeug wird hierbei derart innerhalb der Aussparung positioniert, dass es die in z-Richtung auslenkbaren und/oder beweglichen Komponenten des MEMS-Schallwandlers, insbesondere die Aktuatorstruktur und/oder die Membran, in Position hält, so dass diese beim gegenseitigen Verpressen nicht beschädigt werden. Das Referenzwerkzeug wirkt hierbei folglich als Gegenanschlag. Die zweite Öffnung ist somit vorzugsweise als Montagezuführöffnung für das Referenzwerkzeug ausgebildet.

Vorteilhaft ist es, wenn das erste Gehäuseteil die zweite Öffnung der Aussparung bündig abschließt. Hierdurch endet die Kavität an der zweiten Öffnung. Hierdurch kann das Leiterplattenmodul sehr kompakt ausgebildet werden. Alternativ ist es aber auch vorteilhaft, wenn das erste Gehäuseteil einen Gehäusehohlraum aufweist, der teilweise die Kavität bildet. Hierdurch kann die Kavität durch das erste Gehäuseteil zusätzlich zur Aussparung mit dem Gehäusehohlraum erweiterte werden.

Vorteilhaft ist es, wenn die Leiterplatte als, insbesondere umfangsmäßig geschlossener, Rahmen ausgebildet ist. Auch ist es vorteilhaft, wenn die Leiterplatte aus mehreren Schichten aufgebaut ist. Durch einen schichtweisen Aufbau der Leiterplatte können elektronische Komponenten einfach und kostengünstig in der Leiterplatte integriert bzw. eingebettet werden.

Zusätzlich oder alternativ ist es von Vorteil, wenn in der Leiterplatte, insbesondere in ihrem als Rahmen ausgebildeten Randbereich, ein ASIC eingebettet ist. Passive Zusatzkomponenten sind vorteilhafterweise alternativ oder ergänzend im Randbereich der Leiterplatte eingebettet. Der Rahmen umschließt dabei umlaufend die Aussparung der Leiterplatte, so dass die erste Öffnung und die zweite Öffnung axial zum Rahmen ausgebildet sind. Das Bauvolumen der Leiterplatte kann möglichst effizient genutzt werden, wenn die elektronischen Komponenten, insbesondere ein ASIC und/oder passive Zusatzkomponenten, im Randbereich der Leiterplatte eingebettet sind. Hierdurch kann das Leiterplattenmodul sehr kompakt ausgebildet werden.

Des Weiteren ist es vorteilhaft, wenn derjenige Teil des MEMS-Schallwandlers, der mit der Leiterplatte im Bereich der ersten Öffnung verbunden ist, ein MEMS-Aktuator ist. Der MEMS-Aktuator umfasst vorzugsweise einen Substratrahmen, eine Aktuatorstruktur und/oder ein Koppelelement. Der Substratrahmen weist dabei vorzugsweise eine Substrataussparung auf. Die Aktuatorstruktur ist insbesondere an der der Leiterplatte zugewandten Seite des Substratrahmens befestigt. Die Aktuatorstruktur, die vorzugsweise zumindest einen Cantilever umfasst, ist gegenüber dem Substratrahmen entlang einer z-Achse auslenkbar. Die Aktuatorstruktur ist vorzugsweise aus zumindest einer piezoelektrischen Schicht ausgebildet. Das Koppelelement ist insbesondere in der Substrataussparung angeordnet und/oder an der Aktuatorstruktur, insbesondere an deren freien Ende, befestigt. Der Substratrahmen ist vorzugsweise aus Silizium hergestellt. Fungiert die Schallwandleranordnung als Lautsprecher, so kann die Aktuatorstruktur über den eingebetteten ASIC derart angeregt werden, dass durch den MEMS-Aktuator eine Membran zur Erzeugung von Schallenergie in Schwingung versetzt wird. Fungiert die Schallwandleranordnung als Mikrofon werden die Schwingungen durch die Aktuatorstruktur in elektrische Signale umgewandelt.

Ebenso ist es vorteilhaft, wenn die Breite der Aussparung der Leiterplatte kleiner oder gleich der Breite der Substrataussparung ist. Der MEMS-Lautsprecher kann dadurch von der Leiterplatte, insbesondere von ihrem als Rahmen ausgebildeten Randbereich, getragen werden. Durch die vorteilhafte Ausbildung kann der MEMS-Aktuator auf kostengünstige Weise mit der Leiterplatte verbunden, insbesondere verklebt, werden. Des Weiteren kann die Schallwandleranordnung hierdurch kompakt ausgebildet werden, da die äußere Breite der Leiterplatte reduziert werden kann.

Einen weiteren Vorteil stellt es dar, wenn der MEMS-Aktuator in Richtung der z-Achse unmittelbar benachbart zur Leiterplatte angeordnet ist. Hierdurch kann die Höhe der Leiterplattenanordnung reduziert werden.

Der MEMS-Aktuator wirkt mit der dafür vorgesehenen Membran zusammen. Die Aktuatorstruktur wandelt dabei elektrische Signale in akustisch wahrnehmbare Schallwellen um. Um die Amplitude der Schallwellen zu erhöhen, ist es daher von Vorteil, wenn der MEMS-Aktuator in Richtung der z-Achse stark auslenkbar ist. Dies kann dadurch begünstigt werden, wenn der MEMS-Aktuator in Richtung der z-Achse mittels eines Abstandhalters von der Leiterplatte beabstandet ist. Der Abstandhalter ist vorzugsweise als elektrischer Kontakt ausgebildet, der insbesondere den ASIC mit der Aktuatorstruktur verbindet.

Vorgeschlagen wird zudem eine Schallwandleranordnung zum Erzeugen und/oder Erfassen von Schallwellen im hörbaren Wellenlängenspektrum mit einem Leiterplattenmodul und einem Membranmodul, wobei die Schallwandleranordnung mit einem nachstehend beschriebenen Verfahren hergestellt ist. Das Leiterplattenmodul weist eine Leiterplatte auf. Die Leiterplatte umfasst eine Aussparung und zumindest einen Teil eines MEMS-Schallwandlers, insbesondere einen MEMS-Aktuator. Die Aussparung weist eine erste Öffnung auf. Der Teil des MEMS-Schallwandlers ist im Bereich der ersten Öffnung angeordnet, so dass die Aussparung zumindest teilweise eine Kavität des MEMS-Schallwandlers bildet. Das Membranmodul weist einen Membranrahmen und zumindest eine vom Membranrahmen gehaltene Membran auf. Der Membranrahmen ist mit dem Leiterplattenmodul verbunden. Die Membran ist in der Verlängerung der Aussparung mit dem zumindest einen Teil des MEMS-Schallwandlers verbunden. Das Leiterplattenmodul ist gemäß der vorangegangenen Beschreibung ausgebildet, wobei die genannten Merkmale einzeln oder in beliebiger Kombination vorhanden sein können.

Der modulare Aufbau der Schallwandleranordnung ermöglicht es, die einzelnen Module, insbesondere das Leiterplattenmodul und das Membranmodul, vor dem Zusammenfügen unabhängig voneinander auf seine Funktionsfähigkeit zu testen. Die elektrischen Bauteile, wie z.B. ein ASIC, ein MEMS-Aktuator und/oder passive Zusatzkomponenten, können hinsichtlich ihrer Funktionsfähigkeit überprüft und gegebenenfalls bei einem Defekt aussortiert werden. Vorteilhafterweise erlaubt die erfindungsgemäße Schallwandleranordnung die frühe Identifizierung von fehlerbehafteten Modulen. Die Anzahl defekter Schallwandleranordnungen kann auf diese Weise reduziert werden, wodurch Kosten eingespart werden. Ebenso kann durch die durchgängige Leiterplattenaussparung ein Herstellungsverfahren gewählt werden, bei dem die empfindlichen Bauteile des MEMS-Schallwandlers, nämlich insbesondere die Aktuatorstruktur und/oder die Membran, nicht beschädigt werden. In die Aussparung, die sich von der zweiten Öffnung bis zu der ersten Öffnung erstreckt, kann somit über die zweite Öffnung ein Referenzwerkzeug eingeführt werden, das im Bereich der flexiblen Aktuatorstruktur positionierbar ist. Zum Verbinden des MEMS-Aktuators mit der Membran werden diese miteinander verpresst. Hierbei kann die Aktuatorstruktur und/oder die Membran durch das Referenzwerkzeug in Position gehalten werden, so dass diese nicht über ihren maximal zulässigen Auslenkungsbereich ausgelenkt werden. Somit kann eine Beschädigung der Aktuatorstruktur und/oder der Membran beim Verkleben und/oder Verpressen vermieden werden.

Des Weiteren ist es vorteilhaft, wenn die Membran in einem inneren ersten Verbindungsbereich, insbesondere mittelbar (d.h. über zumindest ein dazwischen angeordnetes Element, insbesondere ein Koppelelement), mit einer Aktuatorstruktur eines MEMS-Aktuators verbunden ist. Durch die Aktuatorstruktur kann eine Hubbewegung erzeugt werden, mittels derer die Membran ausgelenkbar ist.

Besonders vorteilhaft ist es, wenn der erste Verbindungsbereich zwischen einem an der Aktuatorstruktur angeordneten Koppelelement des MEMS-Aktuators und der Membran, insbesondere einem Verstärkungselement der Membran, ausgebildet ist. Durch das Verstärkungselement ist die empfindliche Membran vor Beschädigungen durch zu große Bewegungen der Membran aufgrund von zu hohem Schalldruck oder äußeren Erschütterungen oder Stößen geschützt.

Ebenso ist es vorteilhaft, wenn der Membranrahmen in einem äußeren zweiten Verbindungsbereich, mittelbar und/oder unmittelbar mit der Leiterplatte verbunden ist. Das Membranmodul ist somit im zwischen der Membran und dem Koppelement ausgebildeten ersten Verbindungsbereich sowie über den zwischen dem Membranrahmen und der Leiterplatte ausgebildeten zweiten Verbindungsbereich mit dem Leiterplattenmodul verbunden. Die als Rahmen ausgebildete Leiterplatte, insbesondere deren dem Membranmodul zugewandte Stirnseite, dient dabei als umlaufende Aufnahmefläche für den Membranrahmen, so dass eine stabile und sichere Verbindung hergestellt werden kann.

Ebenso bringt es Vorteile mit sich, wenn die Schallwandleranordnung, insbesondere das Leiterplattenmodul, ein die Kavität verschließendes erstes Gehäuseteil aufweist. Diesbezüglich ist es von Vorteil, wenn der erste Gehäuseteil teilweise die Kavität ausbildet. Somit ist es möglich die Schallwandleranordnung gemäß den Anforderungen individuell zu gestalten. Der Schalldruck und somit der von einer Schallwandleranordnung erzeugbare Ton ist maßgeblich von der Kavität bestimmt. Um die Leistung zu verbessern, kann die Kavität bei Bedarf durch das erste Gehäuseteil beliebig vergrößert werden. Bei sehr begrenztem Bauraum ist es vorteilhaft, wenn die Kavität an der zweiten Öffnung endet. Hierbei ist die zweite Öffnung vorzugsweise mittels des ersten Gehäuseteils verschlossen, so dass die Größe der Kavität von der ersten Öffnung ausgehend in Richtung der zweiten Öffnung alleine durch die Aussparung definiert ist. In diesem Fall ist das erste Gehäuseteil vorzugsweise plan und/oder plattenförmig ausgebildet.

Vorteilhaft ist es, wenn das erste Gehäuseteil auf der dem MEMS-Schallwandler abgewandten Seite der Leiterplatte angeordnet, insbesondere mit dieser verklebt, ist. Ferner ist es vorteilhaft, wenn das erste Gehäuseteil die Leiterplatte, insbesondere in ihrem Randbereich, vorzugsweise formschlüssig umgreift. Die Aussparung der Leiterplatte kann im Zuge des Herstellungsverfahrens einfach und kostengünstig mit dem ersten Gehäuseteil verschlossen werden.

Um eine akustische Anregung des ersten Gehäuseteils vermeiden zu können, ist dieser vorzugsweise aus einem im Vergleich zum Substratrahmen und/der der Leiterplatte steiferen Material, insbesondere einem Metall, einer Keramik und/oder einem Verbundwerkstoff hergestellt. Es bringt demnach Vorteile mit sich, wenn der Substratrahmen, die Leiterplatte und/oder das erste Gehäuseteil aus zueinander unterschiedlichen Materialien ausgebildet sind. Der Substratrahmen und/oder zumindest teilweise das Koppelelement sind vorzugsweise aus Silizium hergestellt. Die Leiterplatte kann aus einem Kunststoff und/oder einem Faserverbundwerkstoff ausgebildet sein.

Vorgeschlagen wird zudem ein Verfahren zum Herstellen einer Schallwandleranordnung. Die Schallwandleranordnung ist vorzugsweise gemäß der vorangegangenen Beschreibung ausgebildet, wobei die genannten Merkmale einzeln oder in beliebiger Kombination vorhanden sein können. Bei dem vorgeschlagenen Herstellungsverfahren wird ein Membranmodul mit einem Leiterplattenmodul verbunden. Das Leiterplattenmodul ist vorzugsweise gemäß der vorangegangenen Beschreibung ausgebildet, wobei die genannten Merkmale einzeln oder in beliebiger Kombination vorhanden sein können. Bei dem Herstellungsverfahren werden eine Membran des Membranmoduls und eine Aktuatorstruktur des Leiterplattenmoduls zwischen einem Pressstempel und einem Referenzwerkzeug positioniert. Die beiden Module, d.h. das Membranmodul und das Leiterplattenmodul, werden zwischen dem Pressstempel und dem Referenzwerkzeug verpresst. Das Membranmodul und das Leiterplattenmodul werden hierbei in einem ersten Verbindungsbereich, der zwischen der Membran und der Aktuatorstruktur ausgebildet wird, miteinander verbunden, insbesondere verklebt. Die Membran sowie die Aktuatorstruktur sind beide entlang einer gemeinsamen z-Achse auslenkbar.

Bevor die beiden Module miteinander verbunden werden, wird zunächst, insbesondere in einem separaten Herstellungsschritt, das Leiterplattenmodul hergestellt, wobei die Aktuatorstruktur an einer Leiterplatte im Bereich einer ersten Öffnung einer Aussparung befestigt wird. Vor dem Verpressen der beiden Module wird das Referenzwerkzeug in die Aussparung eingeführt. Das Referenzwerkzeug wird dabei über eine der ersten Öffnung gegenüberliegende zweite Öffnung in die Aussparung eingeführt und innerhalb dieser positioniert. Die Positionierung erfolgt in solcher Art und Weise, dass die Aktuatorstruktur und/oder die Membran beim Verpressen durch das Referenzwerkzeug innerhalb eines maximal zulässigen Auslenkungsbereichs in Position gehalten werden. Dieser Auslenkungsbereich wird durch die Membran sowie die Aktuatorstruktur definiert und kann je nach Gegebenheiten variieren. Maßgeblichen Einfluss haben dabei die verwendeten Materialien der Membran und/oder der Aktuatorstruktur. Durch das erfindungsgemäße Herstellungsverfahren kann sichergestellt werden, dass die flexible Aktuatorstruktur sowie die empfindliche Membran nicht über ihren jeweils maximal zulässigen Auslenkungsbereich in z-Richtung ausgelenkt werden, wodurch diese Schaden nehmen könnten. Stattdessen werden diese durch das Referenzwerkzeug in z-Richtung gestützt. Das Referenzwerkzeug wirkt demnach als Anschlagsfläche, mittel der die Aktuatorstruktur und die Membran während des Verpressens in Position gehalten werden. Dies wirkt sich ferner vorteilhaft auf die Qualität der Schallwandleranordnung aus. Die Kosten für das Verfahren zur Herstellung einer Schallwandleranordnung können zudem reduziert werden, da nur wenige Arbeitsschritte notwendig sind und weniger Ausschuss produziert wird.

Vorteilhaft ist es, wenn das Referenzwerkzeug so weit in die Aussparung eingeführt wird, bis es an der Aktuatorstruktur zum Anliegen kommt. Die flexible, insbesondere in z-Richtung auslenkbare, Aktuatorstruktur, kann auf diese Weise in ihrer Neutralstellung gehalten werden, so dass keine Schäden entstehen können, welche die Funktionsfähigkeit des Schallwandlers einschränken würden. Des Weiteren kann hierdurch die Qualität der Schallwandleranordnung verbessert werden.

Ebenso bringt es Vorteile mit sich, wenn das Leiterplattenmodul im Bereich der Aktuatorstruktur von dem Referenzwerkzeug und/oder im Bereich der Leiterplatte von einem Haltewerkzeug gehalten wird. Das Referenzwerkzeug und das Haltewerkzeug können einteilig oder zweiteilig ausgebildet sein. Bei einer zweiteiligen Ausführung ist es vorteilhaft, wenn das Referenzwerkzeug zum Einführen in die Aussparung relativ zum Haltewerkzeug verfahren wird. Das Haltewerkzeug ist demnach vorzugsweise ortsfest.

Vorteilhaft ist es, wenn das Leiterplattenmodul, insbesondere mit ihrer Aussparung, auf das korrespondierende Referenzwerkzeug gelegt wird und/oder von dem Haltewerkzeug formschlüssig in Position gehalten wird. Auch ist es vorteilhaft, wenn anschließend im ersten und/oder zweiten Verbindungsbereich ein Klebemittel aufgebracht wird.

Auch ist es vorteilhaft, wenn das Haltewerkzeug teilweise an der dem Membranmodul abgewandten Seite des Leiterplattenmoduls, insbesondere an der Leiterplatte, positioniert wird. Alternativ oder ergänzend wird das Referenzwerkzeug im Bereich der Aussparung positioniert. Das Leiterplattenmodul wird somit in einfacher Art und Weise und ohne teures Spezialwerkzeug für die Verbindung mit dem Membranmodul bereitgestellt.

Vorteilhaft ist es, wenn ein Greifer das Membranmodul an einem Membranrahmen greift und/oder auf das Leiterplattenmodul setzt. Zusätzlich oder alternativ wird der Greifer zum Verbinden in einem zweiten Verbindungsbereich an dem Leiterplattenmodul, insbesondere im äußeren Bereich der Leiterplatte, positioniert und/oder mit diesem verpresst, insbesondere in einem ersten und zweiten Verbindungsbereich. Das Membranmodul kann auf diese Weise am bereitgestellten Leiterplattenmodul positioniert werden. Dabei wird vorzugsweise der Membranrahmen an der als Rahmen ausgebildeten Leiterplatte positioniert, so dass diese im zweiten Verbindungsbereich miteinander verpresst werden. Gleichzeitig wird die Membran mittelbar an der Aktuatorstruktur positioniert, so dass der erste Verbindungsbereich ausgebildet wird. In Folge der Positionierung mit Hilfe des Halte- und Referenzwerkszeugs zum einen und dem Greifer zum anderen, sind die beiden Module derart fixiert, dass sie sicher miteinander verpresst werden können. Das Verpressen der beiden Module kann in den beiden Verbindungsbereichen gleichzeitig oder nacheinander erfolgen. Bei einem sequentiellen Verpressen wird vorzugsweise zuerst der zweite Verbindungsbereich, vorzugsweise im Zuge des Positionierens auf dem Leiterplattenmodul, und erst anschließend der erste Verbindungsbereich verpresst.

Des Weiteren ist es vorteilhaft, wenn der Pressstempel gegenüber dem Greifer in z-Richtung verschoben wird. Nach der ordnungsgemäßen Positionierung der beiden Module werden diese durch die vom Pressstempel ausgehende Kraft miteinander verpresst. Nach dem Verpressen und/oder Aushärten eines Verbindungsmittels, insbesondere eines im jeweiligen Verbindungsbereich aufgetragenen Klebers, können der Pressstempel, der Greifer und/oder das Referenzwerkzeug von der Schallwandleranordnung entfernt werden.

Einen weiteren Vorteil stellt es dar, wenn die Schallwandleranordnung nach dem Verpressen und/oder Verbinden der beiden Module mit zumindest einem Gehäuseteil verbunden wird. Hierbei können die Leiterplatte und/oder der Membranrahmen einen Teil des Außengehäuses bilden. Durch das Gehäuse sind die empfindlichen Bauteile der Schallwandleranordnung vor äußeren Einflüssen geschützt.

Vorteilhaft ist es, wenn nach dem Verbinden der beiden Module die zweite Öffnung der Aussparung mit einem ersten Gehäuseteil verschlossen wird. Hierfür wird das erste Gehäuseteil vorzugsweise an einer dem Membranmodul abgewandten Stirnseite mit der Leiterplatte verklebt.

Weitere Vorteile der Erfindung sind nachfolgend beschrieben. Es zeigt:
- **Figur 1**: ein Leiterplattenmodul in einer Schnittansicht,
- **Figur 2**: ein Membranmodul in einer Schnittansicht,
- **Figur 3**: ein Verfahren gemäß einem Ausführungsbeispiel zum Verbinden des Leiterplattenmoduls mit dem Membranmodul zum Ausbilden einer Schallwandleranordnung in einer Verbindungspresse,
- **Figur 4**: eine Schnittansicht der gemäß der in Figur 3 dargestellten Verbindungspresse hergestellten Schallwandleranordnung gemäß einem ersten Ausführungsbeispiel,
- **Figur 5**: ein zweites Ausführungsbeispiel der Schallwandleranordnung in einer perspektivischen Darstellung,
- **Figur 6**: ein drittes Ausführungsbeispiel der Schallwandleranordnung in einer perspektivischen Darstellung und
- **Figur 7**: ein viertes Ausführungsbeispiel der Schallwandleranordnung in einer perspektivischen Darstellung.

Bei der nachfolgenden Figurenbeschreibung werden, um die Beziehungen zwischen den verschiedenen Elementen zu definieren, bezugnehmend auf die jeweils in den Figuren dargestellte Lage der Objekte relative Begriffe, wie beispielsweise oberhalb, unterhalb, oben, unten, darüber, darunter, links, rechts, vertikal und horizontal, verwendet. Es versteht sich von selbst, dass sich diese Begrifflichkeiten bei einer Abweichung von der in den Figuren dargestellten Lage der Vorrichtungen und/oder Elemente verändern können. Demnach würde beispielsweise bei einer in Bezug auf die Figuren dargestellten invertierten Orientierung der Vorrichtungen und/oder Elemente ein in der nachfolgenden Figurenbeschreibung als oberhalb spezifiziertes Merkmal nunmehr unterhalb angeordnet sein. Die verwendeten Relativbegriffe dienen somit lediglich zur einfacheren Beschreibung der relativen Beziehungen zwischen den einzelnen im nachfolgenden beschriebenen Vorrichtungen und/oder Elemente.

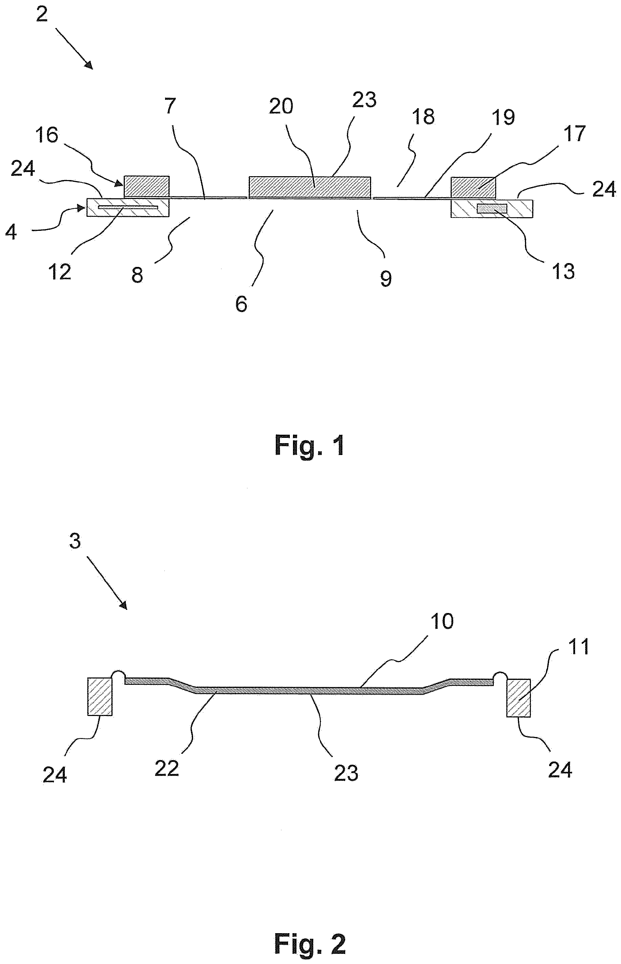

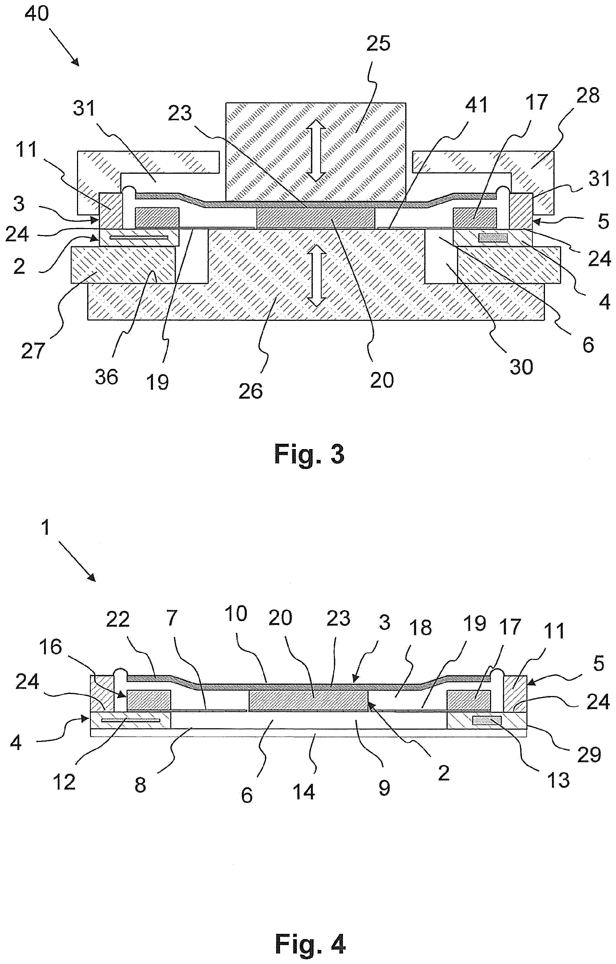

Die Figur 1 zeigt ein Leiterplattenmodul 2 in einer Schnittansicht. Das Leiterplattenmodul 2 umfasst im Wesentlichen eine als Rahmen ausgebildete Leiterplatte 4 und einen Teil eines MEMS-Schallwandlers 5 (vgl. Figur 4). Dieser Teil des MEMS-Schallwandlers 5 ist gemäß dem vorliegenden Beispiel ein MEMS-Aktuator 16. Die Leiterplatte 4 weist eine Aussparung 6 mit einer dem MEMS-Aktuator 16 zugewandten ersten Öffnung 7 und einer der ersten Öffnung 7 gegenüberliegenden zweiten Öffnung 8 auf. Die Aussparung 6 erstreckt sich somit vollständig durch die Leiterplatte 4. Sie ist demnach ein durchgehendes Loch. Die Leiterplatte 4 umfasst einen ASIC 12 und/oder passive Zusatzkomponenten 13, die vollständig in die Leiterplatte 4 integriert sind. Hierfür ist die Leiterplatte 4 schichtweise aufgebaut. Die Leiterplatte ist als umfangsmäßig geschlossener Rahmen ausgebildet, wobei der ASIC 12 und/oder die passiven Zusatzkomponenten 13 im Rahmen bzw. Randbereich eingebettet sind.

Der MEMS-Aktuator 16 umfasst im Wesentlichen eine Aktuatorstruktur 19, einen Substratrahmen 17 und ein Koppelelement 20. Der Substratrahmen 17 weist eine Substrataussparung 18 auf. Im mittleren Bereich der Substrataussparung 18 ist das Koppelelement 20 angeordnet. Über die insbesondere piezoelektrische Aktuatorstruktur 19 ist das Koppelelement 20 mit dem Substratrahmen 17 verbunden. Das Koppelelement 20 und der Substratrahmen 17 sind aus einem Siliziumsubstrat hergestellt weisen die gleiche Dicke auf. Die Aktuatorstruktur 19 ist an der der Leiterplatte 4 zugewandten Seite des Substratrahmens 17 angeordnet. Der MEMS-Aktuator 16, insbesondere die Aktuatorstruktur 19, ist mit der Leiterplatte 4, insbesondere dem ASIC 12 und/oder der zumindest einen passiven Zusatzkomponente 13, elektrisch verbunden.

Die Aktuatorstruktur 19 ist im Bereich der Aussparung 6, insbesondere der ersten Öffnung 7, angeordnet. Die Aussparung 6 ist vorliegend genauso breit wie die Substrataussparung 18 ausgebildet. Der MEMS-Aktuator 16 ist im Bereich des Substratrahmens 17 mit der Leiterplatte 4 verbunden. Die Aktuatorstruktur 19 kann gegenüber dem Substratrahmen 17 und der Leiterplatte 4 in z-Richtung schwingen. Hierbei wird das Koppelelement 20 entlang der z-Achse aus der vorliegend dargestellten Neutralstellung ausgelenkt. Die Aussparung 6 bzw. der Leiterplattenhohlraum bildet zumindest teilweise eine Kavität 9 des in Figur 4 vollständig dargestellten MEMS-Schallwandlers 5.

Das in Figur 1 dargestellte Leiterplattenmodul 2 weist einen ersten Verbindungsbereich 23 auf. Dieser ist an einer der Aktuatorstruktur 19 abgewandten Seite des Koppelelements 20 ausgebildet. Des Weiteren weist das Leiterplattenmodul 2 einen zweiten Verbindungsbereich 24 auf. Dieser ist an einer dem MEMS-Aktuator 16 zugewandten Stirnseite der Leiterplatte 4 ausgebildet. Im ersten und zweiten Verbindungsbereich 23, 24 kann das in Figur 1 dargestellte Leiterplattenmodul 2 mit einem in Figur 2 dargestellten Membranmodul 3 verbunden werden.

Figur 2 zeigt das Membranmodul 3 in einer Schnittansicht, das zum Verbinden mit dem in Figur 1 dargestellten Leiterplattenmodul 2 vorgesehen ist. Das Membranmodul 3 umfasst eine Membran 10. Diese ist in ihrem Randbereich in z-Richtung schwingbar in einem Membranrahmen 11 aufgenommen. Des Weiteren umfasst das Membranmodul 3 ein Verstärkungselement 22 zum Verstärken der Membran 10. Das Verstärkungselement 22 ist an einer Unterseite der Membran 10 angeordnet. Die Membran 10, welche zum Beispiel aus Kautschuk hergestellt ist, ist in ihrem Randbereich fest mit dem Membranrahmen 11 verbunden. Zwischen dem Randbereich und dem Verstärkungselement 22 ist ein elastischer Bereich der Membran 10 ausgebildet.

Dieser weist vorzugsweise eine Wölbung auf. Das Verstärkungselement 22 selbst ist nicht mit dem Membranrahmen 11 verbunden und kann somit gegenüber diesem in z-Richtung schwingen. Die Membran 10 überspannt somit den Membranrahmen 11 und ist in ihrem mittleren Bereich versteift.

Gemäß Figur 2 ist der erste Verbindungsbereich 23 des Membranmoduls 3 in an der Membran 10 in einem mittleren Bereich ausgebildet. Vorliegend ist der erste Verbindungsbereich 23 unmittelbar am Verstärkungselement 22 ausgebildet. In diesem Bereich wird das in Figur 1 dargestellte Koppelelement 20 mit dem Verstärkungselement 22 bzw. mittelbar mit der Membran 10 verbunden.

Der zweite Verbindungsbereich 24 des Membranmoduls 3 ist gemäß Figur 2 stirnseitig am Membranrahmen 11 angeordnet. Beide Verbindungsbereiche 23, 24 sind demnach stirnseitig zur selben Seite hin orientiert.

Figur 3 zeigt eine Verbindungspresse 40 mittels der das in Figur 1 dargestellt Leiterplattenmodul 2 mit dem in Figur 2 dargestellten Membranmodul 3 verbunden werden kann, um eine in Figur 4 dargestellt Schallwandleranordnung 1 herzustellen. Das vormontierte Leiterplattenmodul 2 wird dabei von einem Haltewerkzeug 27 in Position gehalten. Das Haltewerkzeug 27 kommt an der Leiterplatte 4, insbesondere an der dem MEMS-Schallwandler 5 gegenüberliegenden Seite, zum Anliegen. Denkbar ist zudem, dass das Haltewerkzeug 27 die Leiterplatte 4 formschlüssig umgreift, so dass keine laterale Bewegung des Leiterplattenmoduls 2 möglich ist. Das Haltewerkzeug 27 weist eine Werkzeugaussparung 30 auf, die nach der Positionierung des Haltewerkzeugs 27 im an die Aussparung 6 angrenzenden Bereich angeordnet ist. Die Werkzeugaussparung 30 bildet dabei eine Verlängerung der Aussparung 6. Die Breite der Werkzeugaussparung 30 ist größer, gleich oder kleiner der Breite der Aussparung 6.

Die Verbindungspresse 40 umfasst ferner ein Referenzwerkzeug 26. Dieses ist schmaler als die Werkzeugaussparung 30, so dass das Referenzwerkzeug 26 in die Werkzeugaussparung 30 ein- und ausführbar ist. Das Referenzwerkzeug 26 ist demnach entlang der z-Achse gegenüber dem Haltewerkzeug 27 axialverschiebbar. Das Referenzwerkzeug 26 wird vordem Verpressen in die Aussparung 6 der Leiterplatte 4 eingeführt. Gemäß dem vorliegenden Beispiel wird das Referenzwerkzeug 26 soweit in die Aussparung 6 eingeführt, bis es mit einer, insbesondere planen, Stützfläche 41 im Bereich der ersten Öffnung 7 am MEMS-Schallwandler 5, insbesondere an der Aktuatorstruktur 19 und/oder dem Koppelelement 20 anliegt. Hierdurch können die in Axialrichtung flexiblen und/oder beweglichen Teile des MEMS-Schallwandlers 5, nämlich insbesondere die Aktuatorstruktur 19, die Membran 10 und/oder das diese beiden Elemente miteinander koppelnde Koppelelement 20, in Position gehalten werden. Damit die Aktuatorstruktur 19 und die Membran 10 beim Verpressen aufgrund von zu starker Auslenkung nicht beschädigt werden, muss das Referenzwerkzeug 26 nicht zwingend an der Aktuatorstruktur 19 in der dargestellten Neutralstellung anliegen. Es kann ebenso auch innerhalb des maximal zulässigen Auslenkungsbereiches der Aktuatorstruktur 19 und/oder der Membran 10 von dieser beabstandet sein. In diesem Fall würde die Aktuatorstruktur 19 somit erst beim Verpressen an der Stützfläche 41 zum Anliegen kommen. Um das Referenzwerkzeug 26 zuverlässig in der gewünschten Stützposition positionieren zu können, weist das Referenzwerkzeug 26 einen Axialanschlag 36 auf. Mit diesem schlägt das Referenzwerkzeug 26 in seiner in Figur 3 dargestellten Stützendlage am Haltewerkzeug 27 an.

Die Verbindungspresse 40 umfasst ferner einen Greifer 28. Der Greifer 28 greift das Membranmodul 3 an seinem Membranrahmen 11, insbesondere an der die Membran 10 aufweisenden Seite des Membranmoduls 3, um es an dem Leiterplattenmodul 2 auszurichten und zu positionieren. Der Greifer 28 weist eine Greiferaussparung 31 auf, die sich nach dem Greifen des Membranmoduls 3 über dem mittleren Bereich der Membran 10 befindet und den Greifer 28 im auslenkbaren Membranbereich von der Membran 10 beabstandet.

Die beiden Module 2, 3 werden mittels des Greifers 28 derart zueinander positioniert, dass die beiden Module 2, 3 in dem ersten Verbindungsbereich 23 und dem zweiten Verbindungsbereich 24 aneinander liegen. Im ersten Verbindungsbereich 23 werden die beiden in z-Richtung auslenkbaren Teile - nämlich die Membran 10 und die Aktuatorstruktur 19 - des MEMS-Schallwandlers 5 miteinander verbunden. Im dargestellten Beispiel ist der erste Verbindungsbereich 23 zwischen dem Verstärkungselement 22 des Membranmoduls 3 und dem Koppelelement 20 des Leiterplattenmoduls 2 ausgebildet. Es ist jedoch auch denkbar, dass die Membran 10 direkt mit dem Koppelelement 20 verbunden wird. Hierbei kann das Koppelelement 20 auch mehrteilig ausgebildet sein. In jedem Fall werden das Leiterplattenmodul 2 und das Membranmodul 3 im ersten Verbindungsbereich 23 derart miteinander verbunden, dass die Membran 10 zur Erzeugung von Schallwellen mittels der Aktuatorstruktur 19 in z-Richtung auslenkbar ist. Im zweiten Verbindungsbereich 24 werden die beiden Trägerteile, mittels denen die Aktuatorstruktur 19 bzw. die Membran 10 schwingbar aufgenommen sind - nämlich vorliegend die Leiterplatte 4 und der Membranrahmen 11 - des MEMS-Schallwandlers 5 miteinander verbunden. Der sich rahmenartig erstreckende zweite Verbindungsbereich 24 ist demnach im dargestellten Beispiel zwischen dem Membranrahmen 11, insbesondere an dessen dem Greifer 28 abgewandten Seite, und dem äußeren Bereich der Leiterplatte 4 ausgebildet. Alternativ oder zusätzlich könnte der Membranrahmen 11 aber auch ebenso am Substratrahmen 17 und/oder einem anderen Trägerteil des Leiterplattenmoduls 2 befestigt werden. An beiden Modulen 2, 3 insbesondere an den aneinander anliegenden Flächen der Verbindungsbereiche 23, 24 wird vor der Verbindung ein Klebemittel aufgetragen.

Nachdem die beiden Module 2, 3 aneinander angeordnet und zueinander ausgereichtet sind, werden diese miteinander verpresst. Im zweiten Verbindungsbereich 24 erfolgt das Verpressen der beiden Module 2, 3 zwischen dem Haltewerkzeug 27 und dem Greifer 28. Zum Verpressen der beiden Module 2, 3 im ersten Verbindungsbereich 23 weist die Verbindungspresse 40 einen Pressstempel 25 auf. Dieser ist vorzugsweise ein Bestandteil des Greifers 28 und/oder gegenüber diesem in Axialrichtung verschiebbar. Zum Verpressen der beiden Module 2, 3 im ersten Verbindungsbereich 23 wird der Presstempel 25 durch die Greiferaussparung 31 durchgeführt, bis dieser an der Membran 10 anliegt. Der Presstempel 25 verpresst sodann die beiden Module 2, 3 im ersten Verbindungsbereich 23. Das Referenzwerkzeug 26 bzw. dessen Stützfläche 41 wirkt dabei als Gegenhalter und/oder hält die Aktuatorstruktur 19 und die Membran 10 in Position, insbesondere in ihrer dargestellten Neutralstellung. Nach dem Verpressen und/der Aushärten des Klebemittels wird der Pressstempel 25, der Greifer 28 und/oder das Referenzwerkzeug 26 wieder zurückgefahren.

Figur 4 zeigt eine erste Ausführungsform der nach dem beschriebenen Verfahren hergestellten Schallwandleranordnung 1. Die Schallwandleranordnung 1 gemäß dem vorstehend beschriebenen Verfahren aus dem in Figur 1 dargestellten Leiterplattenmodul 2 und dem in Figur 2 dargestellten Membranmodul 3 hergestellt. Die Schallwandleranordnung 1 weist ein Gehäuse 29 auf. Dieses ist gemäß dem vorliegenden Ausführungsbeispiel teilweise aus dem Membranrahmen 11 und der Leiterplatte 4 ausgebildet. Des Weiteren umfasst die Schallwandleranordnung 1 ein erstes Gehäuseteil 14. Dieses wird nach dem Verpressen der beiden Module 2, 3 an der Schallwandleranordnung 1 befestigt. Das erste Gehäuseteil 14 verschließt die Aussparung 6 auf Seiten der zweiten Öffnung 8. Hierfür ist dieses auf der dem MEMS-Schallwandler 5 abgewandten Seite der Leiterplatte 4 angeordnet, insbesondere bündig mit dieser verklebt. Hierdurch wird eine geschlossene Kavität 9 ausgebildet. Das erste Gehäuseteil 14 ist vorliegend plattenförmig ausgebildet und liegt bündig an der zweiten Öffnung 8 an. Infolgedessen ist die Kavität 9 im Bereich der Leiterplatte 4 und auf der dem MEMS-Aktuator 16 abgewandten Seite der Leiterplatte ausschließlich durch die Aussparung 6 ausgebildet. Das erste Gehäuseteil 14, der Substratrahmen 17 und/oder die Leiterplatte 4 sind vorzugsweise aus zueinander unterschiedlichen Materialien hergestellt.

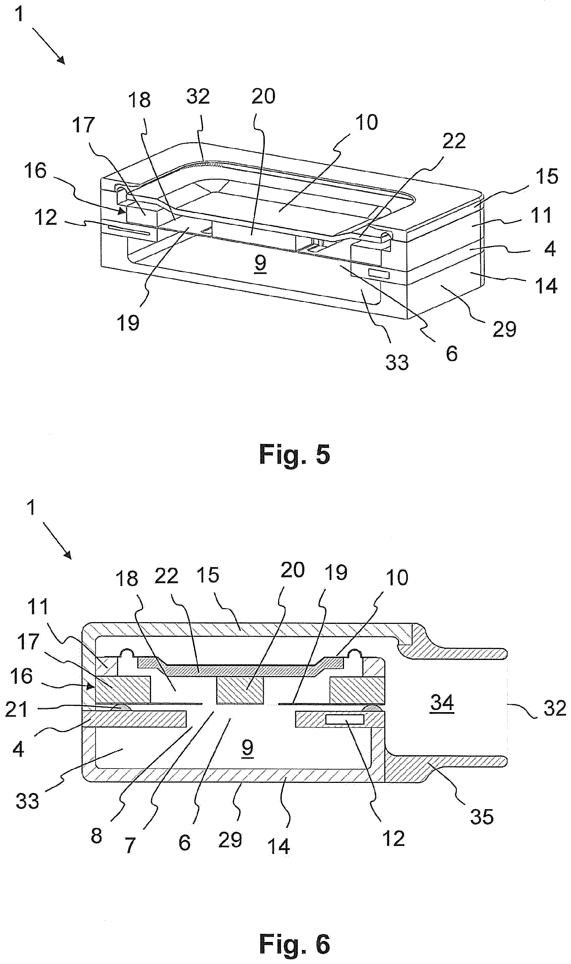

In den Figuren 5 bis 7 sind weitere Ausführungsformen der Schallwandleranordnung 1 gezeigt, wobei jeweils im Wesentlichen auf die Unterschiede in Bezug auf die bereits beschriebene erste Ausführungsform eingegangen wird. So werden bei der nachfolgenden Beschreibung der weiteren Ausführungsformen für gleiche Merkmale gleiche Bezugszeichen verwendet. Sofern diese nicht nochmals detailliert erläutert werden, entspricht deren Ausgestaltung und Wirkweise den vorstehend bereits beschriebenen Merkmalen. Die nachfolgend beschriebenen Unterschiede können mit den Merkmalen der jeweils vorstehenden und nachfolgenden Ausführungsbeispiele kombiniert werden.

Figur 5 zeigt ein zweites Ausführungsbeispiel der Schallwandleranordnung 1 in perspektivischer Darstellung. Das Gehäuse 29 ist hierbei ebenfalls durch den Membranrahmen 11, die Leiterplatte 4 und das erste Gehäuseteil 14 gebildet. Zusätzlich umfasst das Gehäuse 29 jedoch ein zweites Gehäuseteil 15. Das zweite Gehäuseteil 15 ist an der der Leiterplatte 4 abgewandten Seite des MEMS-Schallwandlers 5 angeordnet. Die Membran 10 ist somit zwischen dem Membranrahmen 11 und dem zweiten Gehäuseteil 15 verklebt. Das zweite Gehäuseteil 15 weist eine Schallaustrittsöffnung 32 auf. Durch diese können die Schallwellen, die in Folge der Anregung der Membran 10 durch die Aktuatorstruktur 19 entstehen, aus dem Gehäuse 29 austreten. Die Schallaustrittsöffnung 32 ist gemäß dem vorliegenden Ausführungsbeispiel über dem mittleren Bereich der Membran 10 angeordnet. Das zweite Gehäuseteil 15 schützt den elastischen Bereich der Membran 10, der nicht durch das Verstärkungselement 22 verstärkt ist.

Das erste Gehäuseteil 14 ist stirnseitig an der Leiterplatte 4 befestigt. In einem hier nicht dargestellten Ausführungsbeispiel kann das erste Gehäuseteil 14 die Leiterplatte 4 aber auch in ihrem äußeren Randbereich formschlüssig umgreift. Das erste Gehäuseteil 14 weist im Gegensatz zum in Figur 4 dargestellten Ausführungsbeispiel einen Gehäusehohlraum 33 auf. Dieser bildet zusätzlich zur Aussparung 6 die Kavität 9 aus.

Figur 6 zeigt ein drittes Ausführungsbeispiel der Schallwandleranordnung 1. Das erste Gehäuseteil 14 bildet dabei ebenfalls mittels des Gehäusehohlraums 33 einen Teil der Kavität 9 des MEMS-Schallwandlers 5 aus. Der Gehäusehohlraum 33 grenzt im Bereich der zweiten Öffnung 8 unmittelbar an die Aussparung 6 der Leiterplatte 4 an.

Das zweite Gehäuseteil 15 bildet vorliegend teilweise einen Schallleitkanal 34 aus. Ein weiterer Teil des Schallleitkanals 34 wird von einem dritten Gehäuseteil 35 gebildet. Die Schallaustrittsöffnung 32 ist hierbei am dritten Gehäuseteil 35 ausgebildet. Das dritte Gehäuseteil 35 ist seitlich am ersten und zweiten Gehäuseteil 14, 15 befestigt. Demnach werden die erzeugten Schallwellen von der Membran 10 ausgehend über den im zweiten und dritten Gehäuseteil 15, 35 ausgebildeten Schallleitkanal 34 zur Schallaustrittsöffnung 32 und über diese aus dem Gehäuse 29 der Schallwandleranordnung 1 geleitet.

Gemäß dem in Figur 6 dargestellten Ausführungsbeispiel ist die Aussparung 6 schmaler ausgebildet als die Substrataussparung 18. Um hierdurch eine Einschränkung der maximalen Auslenkbarkeit der Aktuatorstruktur 19 in z-Richtung vermeiden zu können, ist die Aktuatorstruktur 19 von der ersten Öffnung 7 bzw. von der Leiterplatte 4 beabstandet. Hierfür weist die Schallwandleranordnung 1 einen Abstandhalter 21 auf. Der Abstandhalter 21 ist vorzugsweise als elektrischer Kontakt ausgebildet. Er verbindet den ASIC 12 elektrisch mit der Aktuatorstruktur 19 des MEMS-Schallwandlers 5. Der Abstandshalter 21 ist zwischen der Leiterplatte 4 und dem MEMS-Aktuator 16, insbesondere seiner Aktuatorstruktur 19, angeordnet. Der MEMS-Aktuator 16 ist auf diese Weise von der Leiterplatte 4 in z-Richtung beabstandet und stößt somit bei seiner Auslenkung nicht an der Leiterplatte 4 an.

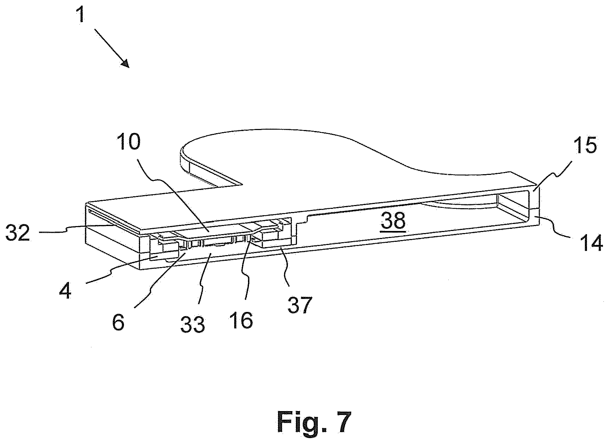

Figur 7 zeigt ein viertes Ausführungsbeispiel der Schallwandleranordnung 1. Hierin ist die Kavität 9 des MEMS-Schallwandlers 5 durch die Aussparung 6 der Leiterplatte 4, dem Gehäusehohlraum 33 und einem Zusatzvolumen 38 ausgebildet. Das Zusatzvolumen 38 und der Gehäusehohlraum 33 sind über einen Verbindungskanal 37 miteinander verbunden. Das Gehäuse des Zusatzvolumens 38 ist durch ein erstes und zweites Gehäuseteil 14, 15 ausgebildet.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: Schallwandleranordnung
- 2: Leiterplattenmodul
- 3: Membranmodul
- 4: Leiterplatte
- 5: MEMS-Schallwandler
- 6: Aussparung
- 7: Erste Öffnung
- 8: Zweite Öffnung
- 9: Kavität
- 10: Membran
- 11: Membranrahmen
- 12: ASIC
- 13: passive Zusatzkomponenten
- 14: erstes Gehäuseteil
- 15: zweites Gehäuseteil
- 16: MEMS-Aktuator
- 17: Substratrahmen
- 18: Substrataussparung
- 19: Aktuatorstruktur
- 20: Koppelelement
- 21: Abstandhalter
- 22: Verstärkungselement
- 23: erster Verbindungsbereich
- 24: zweiter Verbindungsbereich
- 25: Presstempel
- 26: Referenzwerkzeug
- 27: Haltewerkzeug
- 28: Greifer
- 29: Gehäuse
- 30: Werkzeugaussparung
- 31: Greiferaussparung
- 32: Schallaustrittsöffnung
- 33: Gehäusehohlraum
- 34: Schallleitkanal
- 35: drittes Gehäuseteil
- 36: Axialanschlag
- 37: Verbindungskanal
- 38: Zusatzvolumen
- 39: Volumengehäuse
- 40: Verbindungspresse
- 41: Stützfläche

## Patentansprüche

1. Verfahren zum Herstellen einer Schallwandleranordnung (1) bei dem ein Membranmodul (3) mit einem Leiterplattenmodul (2) verbunden wird,
wobei eine Membran (10) des Membranmoduls (3) und eine Aktuatorstruktur (19) des Leiterplattenmoduls (2), die beide entlang einer gemeinsamen z-Achse auslenkbar sind, zwischen einem Pressstempel (25) und einem Referenzwerkzeug (26) positioniert werden und zwischen diesen beiden verpresst werden, so dass sich die beiden Module (2, 3) in einem ersten Verbindungsbereich (23) miteinander verbinden,
**dadurch gekennzeichnet.**
**dass** beim Herstellen des Leiterplattenmoduls (2) die Aktuatorstruktur (19) an einer Leiterplatte (4) im Bereich einer ersten Öffnung (7) einer Aussparung (6) befestigt wird und
**dass** vor dem Verpressen der beiden Module (2, 3) das Referenzwerkzeug (26) über eine der ersten Öffnung (7) gegenüberliegende zweite Öffnung (8) in die Aussparung (6) eingeführt wird und innerhalb dieser derart positioniert wird, dass die Aktuatorstruktur (19) und/oder die Membran (10) beim Verpressen durch das Referenzwerkzeug (26) in Position gehalten werden.

2. Verfahren nach dem vorherigen Anspruch, **dadurch gekennzeichnet, dass** das Referenzwerkzeug (26) so weit in die Aussparung (6) eingeführt wird, bis es an der Aktuatorstruktur (19) zum Anliegen kommt.

3. Verfahren nach einem oder mehreren der vorherigen Ansprüche,
**dadurch gekennzeichnet, dass** das Leiterplattenmodul (2) im Bereich der Aktuatorstruktur (19) von dem Referenzwerkzeug (26) und/oder im Bereich der Leiterplatte (4) von einem Haltewerkzeug (27) gehalten wird.

4. Verfahren nach Anspruch 3 **dadurch gekennzeichnet, dass** das Haltewerkzeug (27) teilweise an der dem Membranmodul (3) abgewandten Seite des Leiterplattenmoduls (2) und/oder das Referenzwerkzeug (26) im Bereich der Aussparung (6) positioniert wird.

5. Verfahren nach einem oder mehreren der vorherigen Ansprüche,
**dadurch gekennzeichnet, dass** ein Greifer (28) das Membranmodul (3) an einem Membranrahmen (11) greift und/oder zum Verbinden in einem zweiten Verbindungsbereich (24) an dem Leiterplattenmodul (2) positioniert und/oder mit dieser verpresst.

6. Verfahren nach Anspruch 5 **dadurch gekennzeichnet, dass** der Pressstempel (25) zum Verpressen des ersten Verbindungsbereiches gegenüber dem Greifer (28) und/oder dem Referenzwerkzeug (26) verschoben wird.

7. Verfahren nach einem oder mehreren der vorherigen Ansprüche, **dadurch gekennzeichnet, dass** die Schallwandleranordnung (1) nach dem Verpressen mit einem eine Kavität (9) der Schallwandleranordung (1) verschließenden ersten Gehäuseteil (14) verbunden wird.

8. Schallwandleranordnung (1) zum Erzeugen und/oder Erfassen von Schallwellen im hörbaren Wellenlängenspektrum mit einem Leiterplattenmodul (2), das
eine Leiterplatte (4) mit einer eine erste Öffnung (7) aufweisenden Aussparung (6) und
zumindest einen Teil eines MEMS-Schallwandlers (5) umfasst, wobei dieser Teil im Bereich der ersten Öffnung (7) angeordnet ist, so dass die Aussparung (6) zumindest teilweise eine Kavität (9) des MEMS-Schallwandlers (5) bildet,
wobei die Aussparung (6) eine der ersten Öffnung (7) gegenüberliegende zweite Öffnung (8) aufweist, so dass sich die Aussparung (6) vollständig durch die Leiterplatte (4) erstreckt und
wobei das Leiterplattenmodul (2) im Bereich der zweiten Öffnung (8) ein erstes Gehäuseteil (14) umfasst, das die Kavität (9) verschließt, und
mit einem Membranmodul (3),
das einen Membranrahmen (11), der mit dem Leiterplattenmodul (2) verbunden ist, und
zumindest eine vom Membranrahmen (11) gehaltene Membran (10) aufweist, wobei die Membran (10) in der Verlängerung der Aussparung (6) mit dem zumindest einen Teil des MEMS-Schallwandlers (5) verbunden ist,
**dadurch gekennzeichnet.**
**dass** die Schallwandleranordung (1) durch ein Verfahren nach einem oder mehreren der vorherigen Ansprüche ausgebildet ist.

9. Schallwandleranordnung nach dem vorherigen Anspruch, **dadurch gekennzeichnet, dass** die Membran (10) in einem inneren ersten Verbindungsbereich (23) mit einer Aktuatorstruktur (19) eines MEMS-Aktuators (16) verbunden ist, wobei der erste Verbindungsbereich (23) zwischen einem an der Aktuatorstruktur (19) angeordneten Koppelelement (20) des MEMS-Aktuators (16) und der Membran (10) ausgebildet ist.

10. Schallwandleranordnung nach dem vorherigen Anspruch, **dadurch gekennzeichnet, dass** der Membranrahmen (11) in einem äußeren zweiten Verbindungsbereich (24) mittelbar und/oder unmittelbar mit der Leiterplatte (4) verbunden ist.

11. Schallwandleranordnung nach einem oder mehreren der vorherigen Ansprüche, **dadurch gekennzeichnet, dass** das erste Gehäuseteil (14) die zweite Öffnung (8) der Aussparung (6) bündig abschließt oder einen Gehäusehohlraum (33) aufweist, der teilweise die Kavität (9) bildet.

12. Schallwandleranordnung nach einem oder mehreren der vorherigen Ansprüche, **dadurch gekennzeichnet, dass** die Leiterplatte (4) als Rahmen ausgebildet ist, aus mehreren Schichten aufgebaut ist und/oder ein ASIC (12) und/oder passive Zusatzkomponenten (13) eingebettet sind.

## Claims

1. A method for producing a sound transducer arrangement (1) in which a membrane module (3) is connected to a circuit board module (2),
a membrane (10) of the membrane module (3) and an actuator structure (19) of the circuit board module (2), both deflectable along a common Z-axis, being positioned between a press punch (25) and a reference tool (26) and being pressed between these two, so that the two modules (2, 3) connect to each other in a first connecting region (23),
**characterized in that**
the actuator structure (19) is attached to a circuit board (4) in the region of a first opening (7) of a recess (6) when producing the circuit board module (2), and
that before the two modules (2,3) are pressed the reference tool (26) is inserted into the recess (6) via a second opening (8) opposite the first opening (7) and is positioned within the same such that the actuator structure (19) and/or the membrane (10) are held in position by the reference tool (26) when pressing.

2. The method according to the preceding claim, **characterized in that** the reference tool (26) is inserted into the recess (6) until making contact with the actuator structure (19).

3. The method according to any one or more of the preceding claims, **characterized in that** the circuit board module (2) is held by the reference tool (26) in the region of the actuator structure (19) and/or by a holding tool (27) in the region of the circuit board (4).

4. The method according to claim 3, **characterized in that** the holding tool (27) is positioned partially on the side of the circuit board module (2) facing away from the membrane module (3) and/or the reference tool (26) is positioned in the region of the recess (6).

5. The method according to any one or more of the preceding claims, **characterized in that** a gripper (28) grips the membrane module (3) by a membrane frame (11) and/or positions the same at the circuit board module (2) for connecting in a second connecting region (24) and/or presses the same with said module.

6. The method according to claim 5, **characterized in that** the press punch (25) is shifted relative to the gripper (28) and/or the reference tool (26) for pressing the first connecting region.

7. The method according to any one or more of the preceding claims, **characterized in that** the sound transducer arrangement (1) is connected to a first housing part (14) closing off a cavity (9) of the sound transducer arrangement (1) after pressing.

8. A sound transducer arrangement (1) for producing and/or detecting sound waves in the audible wavelength spectrum, having a circuit board module (2)
comprising a circuit board (4) having a recess (6) comprising a first opening (7) and
comprising at least one part of a MEMS sound transducer (5), said part being disposed in the region of the first opening (7), so that the recess (6) at least partially forms a cavity (9) of the MEMS sound transducer (5),
the recess (6) comprising a second opening (8) opposite the first opening (7), so that the recess (6) extends completely through the circuit board (4),
and the circuit board module (2) comprising a first housing part (14) in the region of the second opening (8), said housing part closing off the cavity (9),
and
having a membrane module (3)
comprising a membrane frame (11) connected to the circuit board module (2) and
at least one membrane (10) held by the membrane frame (11), the membrane (10) being connected to the at least one part of the MEMS sound transducer (5) in the extension of the recess (6), **characterized in that** the sound transducer (1) is implemented by a method according to any one or more of the preceding claims.

9. The sound transducer arrangement according to the preceding claim, **characterized in that** the membrane (10) is connected to an actuator structure (19) of an MEMS actuator (16) in a first connecting region (23), wherein the first connecting region (23) is implemented between a coupling element (20) of the MEMS actuator (16) disposed on the actuator structure (19) and the membrane (10).

10. The sound transducer arrangement according to the preceding claim, **characterized in that** the membrane frame (11) is directly and/or indirectly connected to the circuit board (4) in an outer second connecting region (24).

11. The sound transducer arrangement according to any one or more of the preceding claims, **characterized in that** the first housing part (14) flushly closes off the second opening (8) of the recess (6) or comprises a housing hollow space (33) partially forming the cavity (9).

12. The sound transducer arrangement according to any one or more of the preceding claims, **characterized in that** the circuit board (4) is implemented as a frame, being constructed of a plurality of layers, and/or having an ASIC (12) and/or passive ancillary components (13) embedded.

## Revendications

1. Procédé pour fabriquer un ensemble de transducteur acoustique (1), dans lequel un module à membrane (3) est relié à un module de carte imprimée (2),
dans lequel une membrane (10) du module à membrane (3) et une structure d'actionneur (19) du module de carte imprimée (2), qui peuvent toutes les deux être défléchies le long d'un axe z commun, sont positionnées entre un poinçon-ébaucheur (25) et un outil de référence (26) et sont pressées entre ces deux, de sorte que les deux modules (2, 3) se raccordent l'un à l'autre dans une première région de raccordement (23),
**caractérisé en ce que**
**en ce que** la structure d'actionneur (19) est fixée à une carte imprimée (4) dans la zone d'une première ouverture (7) d'un évidement (6) pendant la production du module de carte imprimée (2) et
**en ce que**, avant le pressage des deux modules (2, 3), l'outil de référence (26) est introduit dans l'évidement (6) par une seconde ouverture (8) faisant face à la première ouverture (7) et est positionné dans l'évidement de telle sorte que la structure d'actionneur (19) et/ou la membrane (10) sont maintenue(s) en position par l'outil de référence (26) lors du pressage.

2. Procédé selon la revendication précédente, **caractérisé en ce que** l'outil de référence (26) est introduit dans l'évidement (6) jusqu'à ce qu'il vienne s'appliquer sur la structure d'actionneur (19).

3. Procédé selon l'une ou plusieurs des revendications précédentes, **caractérisé en ce que** le module de carte imprimée (2) est maintenu dans la zone de la structure d'actionneur (19) par l'outil de référence (26) et/ou dans la zone de la carte imprimée (4) par un outil de maintien (27).

4. Procédé selon la revendication 3, **caractérisé en ce que** l'outil de maintien (27) est positionné partiellement sur le côté du module de carte imprimée (2) détourné du module de membrane (3) et/ou l'outil de référence (26) est positionné dans la zone de l'évidemment (6).

5. Procédé selon l'une ou plusieurs des revendications précédentes, **caractérisé en ce qu'**un préhenseur (28) saisit le module à membrane (3) par un cadre de membrane (11) et/ou le positionne au module de carte imprimée (2) pour le raccordement dans une seconde zone de raccordement (24) et/ou le presse avec le module de carte imprimée.

6. Procédé selon la revendication 5, **caractérisé en ce que** le poinçon-ébaucheur (25), pour presser la première zone de raccordement, est décalé par rapport au préhenseur (28) et/ou à l'outil de référence (26).

7. Procédé selon l'une ou plusieurs des revendications précédentes, **caractérisé en ce que** l'ensemble de transducteur acoustique (1), après le pressage, est relié à une première partie de boîtier (14) bouchant une cavité (9) de l'ensemble de transducteur acoustique (1).

8. Ensemble de transducteur acoustique (1) pour générer et/ou détecter des ondes acoustiques dans le spectre de longueur d'onde audible, avec
un module de carte imprimée (2), qui
comprend une carte imprimée (4) avec un évidemment (6) présentant une première ouverture (7) et
au moins une partie d'un transducteur acoustique MEMS (5), sachant que cette partie est disposée dans la zone de la première ouverture (7), de sorte que l'évidement (6) forme au moins partiellement une cavité (9) du transducteur acoustique MEMS (5),
sachant que l'évidement (6) présente une seconde ouverture (8) faisant face à la première ouverture (7) de sorte que l'évidement (6) s'étende complètement à travers la carte imprimée (4) et
sachant que le module de carte imprimée (2) comprend dans la zone de la seconde ouverture (8) une première partie de boîtier (14) qui ferme la cavité (9),
et
avec un module à membrane (3),
qui présente un cadre de membrane (11) relié avec le module de carte imprimée (2) et
au moins une membrane (10) tenue par le cadre de membrane (11), sachant que la membrane (10) est reliée avec l'au moins une partie du transducteur acoustique MEMS (5) dans le prolongement de l'évidement (6),
**caractérisé en ce que**
l'ensemble de transducteur acoustique (1) est formé selon un procédé selon l'une ou plusieurs des revendications précédentes.

9. Ensemble de transducteur acoustique selon la revendication précédente, **caractérisé en ce que** la membrane (10) est reliée dans une première zone de raccordement intérieure (23) avec une structure d'actionneur (19) d'un actionneur MEMS (16), sachant que la première zone de raccordement (23) est formée entre un élément de couplage (20) de l'actionneur MEMS (16) disposé sur la structure d'actionneur (19) et la membrane (10).

10. Ensemble de transducteur acoustique selon la revendication précédente, **caractérisé en ce que** le cadre de membrane (11) est reliée directement ou indirectement avec la carte imprimée (4) dans une seconde zone de raccordement extérieure (24).

11. Ensemble de transducteur selon l'une ou plusieurs des revendications précédentes, **caractérisé en ce que** la première partie de boîtier (14) ferme de manière affleurée la seconde ouverture (8) de l'évidemment (6) ou présente un espace creux de boîtier(33), qui forme partiellement la cavité (9).

12. Ensemble de transducteur selon l'une ou plusieurs des revendications précédentes, **caractérisé en ce que** la carte imprimée (4) se présente sous la forme d'un cadre, qu'elle est structurée en plusieurs couches et/ou qu'un circuit intégré à application spécifique (ASIC) (12) et/ou que des composants supplémentaires passifs (13) sont incorporés.
